# EUROPÄISCHE PATENTANMELDUNG

(11) **EP 2 461 365 A1**
(43) Veröffentlichungstag der Anmeldung: **06.06.2012**
(21) Anmeldenummer: 11009546.0
(22) Anmeldetag: 02.12.2011
(51) Int. Cl.: H01L 31/02

(54) **Photovoltaik-Modul und Kombination meherer Photovoltaik-Module**

(30) Priorität: 02.12.2010 DE 102010053020
(71) Anmelder: Würth Solar GmbH & Co. KG, 74523 Schwäbisch Hall (DE)
(72) Erfinder: Gross, Karl-Heinz, 74747 Unterwittstadt (DE); Kohler, Martin, 74544 Michelbach a.d. Bilz (DE); Belschner, Werner, 74544 Michelbach a.d. Bilz (DE); Barie, Matthias, 74635 Kupferzell (DE)
(74) Vertreter: Schatt, Markus F.

(57) **Zusammenfassung**

Photovoltaik-Modul (10) mit einer Mehrzahl einzelner Photovoltaik-Zellen (20), aufweisend eine elektrische Anschlussvorrichtung (30) mit Stromanschlüssen (32a, 32b) zur Abgabe von erzeugtem Photovoltaikstrom an ein Verbrauchernetz (100) und eine elektrische Sicherungsvorrichtung (40) mit Sicherungsanschlüssen (42a, 42b) an den Stromanschlüssen (32a, 32b) der elektrischen Anschlussvorrichtung (30) und wenigstens einem Sicherungsschalter (44) über den die Stromanschlüsse (32a, 32b) der elektrischen Anschlussvorrichtung (30) von dem Verbrauchernetz (100) elektrisch getrennt werden können, wobei die elektrische Sicherungsvorrichtung (40) eine Auslösevorrichtung (50)aufweist, die mit einer thermischen Sensitivität und/oder einer Rauchsensitivität gebildet und mit dem Sicherungsschalter (44) derart verbunden ist, dass bei Erkennung einer Temperatur und/oder von Rauch oberhalb eines vorbestimmten Schwellwertes der Sicherungsschalter (44) die Stromanschlüsse (32a, 32b) der elektrischen Anschlussvorrichtung (30) von dem Verbrauchernetz (100) elektrisch trennt, sowie Kombination mehrerer derartiger Photovoltaik-Module (10).

## Beschreibung

Die vorliegende Erfindung betrifft ein Photovoltaik-Modul mit einer Mehrzahl von Photovoltaik-Zellen sowie eine Kombination mehrerer derartiger Photovoltaik-Module, jeweils zum Anschluss an ein Gebäudestromnetz für die Versorgung von Verbrauchern oder elektrisch betriebenen Komponenten eines Gebäudes mit Strom oder zur Einspeisung von Strom in ein regionales Verbrauchernetz.

Photovoltaik-Module sind grundsätzlich bekannt und werden zur Erzeugung von Strom für ein Verbrauchernetz eingesetzt. Dafür sind Photovoltaik-Module zum Teil auf oder an Gebäuden, insbesondere auf oder an Wohngebäuden auf deren Dächern und/oder an deren Fassaden angebracht. Solche Photovoltaik-Module auf Gebäuden können dabei sowohl der Unterstützung des Gebäudestromnetzes, wie auch der Einspeisung in ein regionales Verbrauchernetz dienen. Hierfür sind die bekannten Photovoltaik-Module mit einer elektrischen Anschlussvorrichtung versehen, über welche das jeweilige Photovoltaik-Modul elektrisch mit einem Verbrauchernetz verbunden werden kann.

Aus der DE 10 2008 003 272 A1 ist eine Überwachungseinheit für Photovoltaik-Module bekannt, in der in einer Anschlussdose des Photovoltaik-Moduls mit einer Funktionsmodul-Platine angeordnet ist, auf welcher eine Vielzahl von Funktionsüberwachungsmodulen angeordnet sind. Funktionsmodule können ein Temperatursensor und ein Abschaltmodul sein, welches für eine zentrale Abschaltung des Photovoltaik-Moduls sorgt.

Aus der DE 10 2005 018 173 A1 ist ein Verfahren zur sicheren Abschaltung von Photovoltaikanlagen bekannt. Die Auslösung kann über Rauch-, Wasser-, Gassensoren oder andere Schalteinrichtungen erfolgen.

Aus der DE 10 2008 029 491 A1 eine Schutzvorrichtung mit einer Stromunterbrechungseinrichtung zur Unterbrechung stromführender Leitungen bekannt. Eine Trennung kann mechanisch oder durch pyrotechnische Mittel erfolgen.

Aus der DE 20 2006 007 613 U1 ist eine Photovoltaikanlage mit wenigstens einem Photovoltaikelement zur Dach- oder Freiflächenmontage bekannt, dass eine thermische Sicherung in der elektrischen Verbindungsleitung zwischen dem Photovoltaikelement und der elektrischen Übergabestelle aufweist.

Aus der DE 10 2010 008 542 A1 ist eine Photovoltaikschutzvorrichtung bekannt. Zum Schutz vor elektrischen Schlägen im Notfall ist eine Trenneinrichtung in Wirkverbindung mit einer Sensoreinrichtung vorgesehen, die beispielsweise in Folge eines Feuers ein Auslösesignal an die Trenneinrichtung übermittelt. Ferner kann die Sensoreinrichtung ein Rauchsensor sein.

Aus der DE 20 2007 001 648 U1 ist eine weitere Vorrichtung zur Spannungsfreischaltung von Photovoltaikanlagen im Falle eines Brandes bekannt.

Aus der DE 10 2007 032 605 A1 ist eine Photovoltaikanlage mit mindestens einem Photovoltaikelement sowie elektrischen Verbindungsleitungen zum Bereitstellen von elektrischen Strom bekannt, wobei der Stromfluss und/oder die Spannung und/oder die elektrische Verbindung an mindestens einem Photovoltaikelement und/oder innerhalb mindestens eines Photovoltaikelements und/oder zwischen mehreren Photovoltaikelementen steuerbar ist, sodass es möglich ist, diese bei Bedarf, z.B. im Notfall, komplett von lebensgefährlichen Spannungswerten zu befreien bzw. stromlos zu schalten.

Aus der DE 10 2006 060 815 A1 ist eine Solarenergieerzeugungsanlage mit einem Schaltelement bekannt, das bei fehlendem Freigabesignal das zugeordnete Photovoltaik-Modul spannungslos schaltet und bei vorhandenem Freigabesignal aktiviert.

Insbesondere ist es Aufgabe der vorliegenden Erfindung ein Photovoltaik-Modul sowie eine Kombination mehrerer Photovoltaik-Module zur Verfügung zu stellen, das bzw. die in der Lage ist in einem Notfall, insbesondere in einer Brandsituation, die Stromanschlüsse des Photovoltaik-Moduls möglichst schnell, sicher und effektiv spannungsfrei zu setzen, um das Gebäude für den Rettungseinsatz zu sichern. Gelöst wird diese Aufgabe durch ein Photovoltaik-Modul mit den Merkmalen des Anspruchs 1 sowie durch ein Gebäudestromnetz mit den Merkmalen des Anspruchs 12. Vorteilhafte Ausführungsform ergeben sich unter anderem aus den anschließenden Unteransprüchen.

Nach einem Aspekt der Erfindung ist ein Photovoltaik-Modul mit einer Mehrzahl einzelner Photovoltaik-Zellen vorgesehen, wobei das Photovoltaik-Modul aufweist:
■ eine elektrische Anschlussvorrichtung mit Stromanschlüssen ober Stromanschlussleitungen zur Abgabe von erzeugtem Photovoltaikstrom an ein Verbrauchernetz,
■ eine elektrische Sicherungsvorrichtung mit Sicherungsanschlüssen an den Stromanschlüssen der elektrischen Anschlussvorrichtung und wenigstens einem Sicherungsschalter, über den die Stromanschlüsse der elektrischen Anschlussvorrichtung von dem Verbrauchernetz elektrisch getrennt werden können, wobei die elektrische Sicherungsvorrichtung eine Auslösevorrichtung aufweist, die mit einer thermischen Sensitivität und/oder einer Rauchsensitivität gebildet und mit dem Sicherungsschalter derart verbunden ist, dass auf Erfassen einer Temperatur und/oder von Rauch oberhalb eines vorbestimmten Schwellwertes der Sicherungsschalter die Stromanschlüsse der elektrischen Anschlussvorrichtung von dem Verbrauchernetz elektrisch trennt.

Die Auslösevorrichtung mit einer thermischen Sensitivität und/oder einer Rauchsensitivität kann insbesondere eine Stellvorrichtung sein, die zumindest zwei Stellzustände einnehmen kann und insbesondere mit einer Sensorvorrichtung derart ausgeführt ist, dass die Auslösevorrichtung bei Erfassen eine Temperatur, die über einem vorgegebenen Grenzwert liegt, und/oder bei Erfassen von Rauchanteilen oder Rauchbestandteilen in der Luft, deren Anteil oder Konzentration einen vorgegebenen Grenzwert überschreitet, sich von einem ersten in einen zweiten Stellzustand verändert, wobei der zweite Stellzustand derart realisiert ist, dass die Stromanschlüsse der elektrischen Anschlussvorrichtung von dem Verbrauchernetz elektrisch getrennt sind.

So kann bei bekannten Photovoltaik-Modulen deren Wirkungsweise im Falle von Bränden in Gebäuden, auf denen die Photovoltaik-Module angebracht sind, so beeinflusst werden, dass in einem Notfall, insbesondere in einer Brandsituation, die Stromanschlüsse des Photovoltaik-Moduls möglichst schnell, sicher und effektiv spannungsfrei gesetzt werden, um das Gebäude für den Rettungseinsatz zu sichern, denn Photovoltaik-Module liefern aufgrund der Einstrahlung von Licht, insbesondere Sonnenlicht, elektrische Energie. Diese Energieerzeugung wird durch einen Brand im Gebäude nicht gestoppt, sondern läuft bei andauernder Lichteinstrahlung weiter. Selbst wenn ein dem Photovoltaik-Modul nachgeschalteter Wechselrichter ausgeschaltet ist, stehen daher die Stromanschlüsse der Photovoltaik-Module und die anschließenden Anschlussleitungen unter Strom. Damit besteht die Gefahr des Stromschlages bei Kontakt mit diesen Leitungen. Da die Stromanschlüsse an das Verbrauchernetz durch das Haus verlaufen, stehen diese also auch unter Spannung, wenn die Sicherungen des Gebäudestromnetzes ausgeschaltet haben bzw. ausgeschaltet worden sind. Daher sind Rettungskräfte, insbesondere Feuerwehrleute, bei Notfällen, beispielsweise Bränden, dazu angehalten das Gebäude unter anderem elektrotechnisch zu sichern, also die Sicherungen dieses Netzes auszuschalten, um Verletzungen durch Stromschläge zu vermeiden. Das Ausschalten der Sicherung erzeugt also bei den Rettungskräften das falsche Bewusstsein, dass alle elektrischen Leitungen im Gebäude spannungsfrei und damit ungefährlich sind. Da jedoch, wie oben beschrieben, dies nicht für die Stromanschlüsse der Photovoltaik-Module gilt, stellen diese eine besondere Gefahr dar, da sie nicht mehr als Risiko wahrgenommen werden.

Bei bekannten, an den Photovoltaik-Modulen vorgesehenen Betätigungsschaltern zum spannungsfrei setzen der Stromanschlüsse der Photovoltaik-Module muss dies das Gebäude jedoch bewusst geschehen. Aufgrund der Erfindung muss eine Rettungskraft nicht vor Beginn der Rettungsaktion zu den Photovoltaik-Modulen gelangen, um diesen Schalter zu betätigen und damit die Leitungen im Gebäude spannungsfrei zu setzen. Dies verkürzt die Dauer bis zum Beginn des Rettungseinsatzes entscheidend und hat den weiteren Vorteil, dass eine Person nicht zu den Photovoltaik-Modulen gelangen muss, die zumeist auf dem Dach eines Gebäudes oder an deren Fassade angeordnet sind.

Das erfindungsgemäße Photovoltaik-Modul weist eine Mehrzahl einzelner Photovoltaik-Zellen und eine elektrische Anschlussvorrichtung mit Stromanschlüssen zur Abgabe von von den Photovoltaik-Zellen erzeugten Photovoltaikstrom an ein Verbrauchernetz für elektrische Energie auf. Ein solches Verbrauchernetz kann zum Beispiel ein gebäudeinternes Netz sein. Auch ist es möglich, dass es sich bei dem Verbrauchernetz um ein öffentliches Stromnetz handelt, in welches die Leistung des Photovoltaik-Moduls eingespeist wird. Diese Stromanschlüsse weisen auf: zumindest eine Stromanschluss-Schnittstelle zum Verbinden des jeweiligen Photovoltaik-Moduls mit Anschluss-Leitungen, die zu den Anschlusspunkten des Verbrauchernetzes führen, um die von den Photovoltaik-Zellen erzeugte elektrische Energie bzw. den von den Photovoltaik-Zellen erzeugten elektrischen Strom an das Verbrauchernetz abzugeben. Für den Fall, dass in dem Modul mehrere Photovoltaik-Module elektrisch miteinander gekoppelt sind, weisen die Stromanschlüsse auch Verbindungsleitungen zum elektrischen Verbinden von einzelnen Photovoltaik-Modulen miteinander auf. Auch kann zusätzlich noch ein Wechselrichter vorgesehen sein, der den von dem Photovoltaik-Modul erzeugten Gleichstrom in Wechselstrom wandelt und diesen in das Verbrauchernetz einspeist. Der Wechselrichter kann also Teil der Anschlussvorrichtung sein, insbesondere auch in einer Modulschaltdose oder einem Modulschaltschrank vorgesehen sein.

Weiter weist ein erfindungsgemäßes Photovoltaik-Modul eine elektrische Sicherungsvorrichtung mit Sicherungsanschlüssen an oder integriert in den Stromanschlüssen und insbesondere zumindest einer Stromanschluss-Schnittstelle der elektrischen Anschlussvorrichtung und mit einem Sicherungsschalter auf. Über diesen Sicherungsschalter können die Stromanschlüsse der elektrischen Anschlussvorrichtung von dem Verbrauchernetz elektrisch getrennt werden. Auf diese Weise findet ein Entkoppeln des Photovoltaik-Moduls direkt an den Stromanschlüssen statt, welche zum Beispiel in einer Modulanschlussdose auf dem Dach eines Gebäudes oder an deren Fassade direkt neben der Photovoltaik-Anlage angeordnet sind. Der Sicherungsschalter kann zum Beispiel als Relais ausgebildet sein, welches von einer Steuervorrichtung, zum Beispiel der Steuervorrichtung des Photovoltaik-Moduls, Steuersignale für den gewünschten Schaltzustand erhält. Bei der Ausbildung des Sicherungsschalters in Form eines Relais ist es möglich, dass die Auslösevorrichtung auch einen Relaisstromkreis aufweist, welcher das Relais im Normalzustand mit einem Minimalstrom versorgt und damit den Sicherungsschalter der Sicherungsvorrichtung geschlossen hält. Das Relais weist somit eine Selbsthaltefunktion auf. Der Sicherungsschalter kann dabei derart ausgeführt sein, dass mit Hilfe der Auslösevorrichtung, beispielsweise aufgrund von Signalen von Sensoren und/oder durch Verwendung von temperatursensitiven Materialen in einem entsprechenden Schalterelement, der Relaisstromkreis unterbrochen wird, so dass die Versorgung des Relais mit dem Minimalstrom ausfällt, und sich der Sicherungsschalter öffnet. Das Photovoltaik-Modul wird auf diese Weise also gesichert und vom Verbrauchernetz getrennt.

Auch kann bei einem erfindungsgemäßen Photovoltaik-Modul eine Auslösevorrichtung der elektrischen Sicherungsvorrichtung vorgesehen sein, die eine Vorrichtung und insbesondere einen Sensor mit einer thermischen Sensitivität und/oder einer Rauchsensitivität aufweist und mit dem Sicherungsschalter derart gekoppelt ist, dass der Sicherungsschalter bei Erfassung einer Temperatur oberhalb eines vorbestimmten Schwellwertes und/oder von Rauch mit einer Intensität oberhalb eines vorbestimmten Schwellwertes die elektrische Verbindung zwischen dem jeweiligen Photovoltaik-Modul und dem Verbrauchernetz oder zwischen den Stromanschlüssen der elektrischen Anschlussvorrichtung und dem Verbrauchernetz elektrisch trennt. Die Trennung der Stromanschlüsse von dem Verbrauchernetz hat zur Folge, dass alle nachfolgenden Leitungen des Verbrauchernetzes oder des Gebäudes, die zur elektrischen Anbindung des Photovoltaik-Moduls vorgesehen sind, auf diese Weise spannungsfrei und damit für den Rettungseinsatz gesichert sind. Unter den Begriffen "thermische Sensitivität" und "Rauchsensitivität" ist dabei zu verstehen, dass die Auslösevorrichtung derart ausgeführt ist, dass diese qualitativ und/oder quantitativ eine thermische Schwankung und/oder eine Rauch-Intensität erfassen oder aufgrund einer thermischen Schwankung und/oder einer Rauch-Intensität reagieren kann. Zur Realisierung einer thermischen Sensitivität können beispielsweise Thermofühler verwendet, während zur Realisierung einer Rauchsensitivität beispielsweise ein Rauchmelder eingesetzt werden kann. Grundsätzlich kann die Auslösevorrichtung direkt als ein Teil der Sicherungsvorrichtung realisiert oder auch räumlich zumindest teilweise von dieser getrennt realisiert sein.

Diesbezüglich werden nachfolgend noch einige Ausführungsformen näher erläutert werden. Die einzelnen Photovoltaik-Zellen eines Photovoltaik-Moduls können dabei sowohl in Reihe, als sogenannter Strang oder String, aber auch parallel zueinander geschaltet sein.

Mit anderen Worten ist ein Photovoltaik-Modul der vorliegenden Erfindung in der Lage, die elektrische Verbindung zwischen den Stromanschlüssen und dem Verbrauchernetz sozusagen in vordefinierten Temperatur- und/oder Rauchsituation automatisch zu trennen. Wird von der Auslösevorrichtung eine erhöhte Temperatur, zum Beispiel größer als 100°C und/oder eine Rauchentwicklung sensorisch erfasst, so kann dies mit gewisser Wahrscheinlichkeit auf einen Notfall, insbesondere einen Brand in der Umgebung des betreffenden Photovoltaik-Moduls hinweisen. In diesem Fall dient die Kopplung der Auslösevorrichtung mit dem Sicherungsschalter dazu, dass dieser sich automatisch öffnet und damit die Verbindung zwischen den Stromanschlüssen der Anschlussvorrichtung und dem Verbrauchernetz elektrisch voneinander getrennt wird. Mit anderen Worten wird durch das Öffnen des Sicherungsschalters das Gebäude mit Bezug auf die Leitungen des Photovoltaik-Moduls für den Rettungseinsatz gesichert. Im Gegensatz zu den bekannten Systemen finden auf diese Weise nicht nur grundsätzlich die gewünschte Sicherung des Gebäudes statt, sondern diese Sicherung wird darüber hinaus auch automatisch, also ohne aktives Eingreifen einer Rettungskraft erzielt. Im idealen Fall hat also die Sicherung des Photovoltaik-Moduls bereits stattgefunden, wenn die Rettungskräfte den Einsatzort erreichen.

Ein erfindungsgemäßes Photovoltaik-Modul kann dahingehend weitergebildet sein, dass die Auslösevorrichtung integraler Bestandteil des Sicherungsschalters und/oder der Sicherungsvorrichtung ist. So kann sich die Auslösevorrichtung vorteilhafterweise ebenfalls in der Modulanschlussdose des Photovoltaik-Moduls befinden. Unter "integraler Bestandteil" ist dabei zu verstehen, dass ein Teil der Sicherungsvorrichtung und/oder ein Teil des Sicherungsschalters ausgebildet ist, um als Auslösevorrichtung wirken zu können. Verschiede Ausführungsformen hierzu werden nachfolgend noch näher beschrieben werden. Ein Vorteil, der durch diese integrale Ausbildung erzielt werden kann, ist die sehr kompakte Bauform. So ist es möglich, die Auslösevorrichtung und die Sicherungsvorrichtung in integraler Weise in einem gemeinsamen Gehäuse, zum Beispiel in der Modulanschlussdose vorzusehen. Damit werden Platz und vor allem Kosten gespart, da keine zusätzlichen Leitungen zwischen der Auslösevorrichtung und der Sicherungsvorrichtung angeordnet werden müssen.

Bei einer Ausführungsform des Photovoltaik-Moduls mit integraler Ausbildung der Sicherungsvorrichtung und der Auslösevorrichtung kann es vorteilhaft sein, wenn die Auslösevorrichtung eine Komponente aus Bimetall aufweist, die bei Erhöhung der Temperatur den Sicherungsschalter direkt oder indirekt öffnet.

Ein direktes Öffnen ist beispielsweise dann möglich, wenn der Sicherungsschalter selbst, also insbesondere dessen Schaltmittel, zumindest teilweise aus Bimetall gefertigt ist. Dieser bimetallische Teil ist dabei derart ausgebildet, dass er sich ab Überschreiten einer bestimmten Temperatur von der geschlossenen in die geöffnete Position bewegt und für das Anhalten der Temperatur in dieser geöffneten Position verbleibt. Damit wird die thermische Sensitivität also durch das Vorsehen einer bimetallischen Komponente erzeugt, die über die explizite Materialkombination und die geometrische Anordnung im Sicherungsschalter die genaue Öffnungstemperatur des Sicherungsschalters definieren kann. Diese direkte integrale Ausbildung ist hinsichtlich ihres Platzbedarfs besonders vorteilhaft. Da keine Steuervorrichtung zur Übertragung einer gemessenen Temperatur auf den Sicherungsschalter notwendig ist, ist diese Ausführungsform darüber hinaus hinsichtlich ihrer Funktionalität auch besonders sicher.

Ein indirektes Öffnen des Schalters ist beispielsweise möglich, wenn die bimetallische Komponente derart angeordnet ist, dass sie sich unter Temperatureinwirkung verformen kann und im Verlauf des Weges dieser Verformung den Sicherungsschalter in seine offene Position bewegt. Auch dieses indirekte Öffnen ist ohne eine zusätzliche Steuervorrichtung möglich, so dass auch diese Ausführungsform hinsichtlich ihrer Funktionalität als besonders sicher gelten kann. Der Sicherungsschalter wird also durch die Anbindung an die bimetallische Komponente entweder in die offene Position geschoben oder gezogen.

Nach einer Ausführungsform der vorliegenden Erfindung kann vorgesehen sein, dass die Auslösevorrichtung eine Komponente oder ein Stellteil aus Formgedächtnismaterial aufweist, die bei Erhöhung der Temperatur den Sicherungsschalter in einem ersten Verstellzustand eine elektrische Verbindung in den Stromleitungen oder Stromanschlüssen herstellt und einem zweiten Verstellzustand die elektrische Verbindung in den Stromleitungen oder Stromanschlüssen direkt oder indirekt öffnet. Es kann sich bei dem Formgedächtnismaterial z.B. um eine Formgedächtnislegierung oder ein Formgedächnis-Polymer handeln. Bei einer Formgedächtnislegierung beruht die Formumwandlung bzw. die allotrope Umwandlung auf der temperaturabhängigen Gitterumwandlung zweier verschiedener Kristallstrukturen eines Werkstoffs. Formgedächtnis-Polymere sind Kunststoffe, die einen Shape Memory-Effekt aufweisen, also sich an ihre frühere äußere Form trotz einer zwischenzeitlichen starken Umformung scheinbar "erinnern" können. Formgedächtnis-Polymere können zwei Komponenten aufweisen. Die erste Komponente ist ein elastisches Polymer, die ein Federelement bildet, die zweite Komponente ein aushärtendes Wachs, das das Federelement in jeder gewünschten Form arretieren kann. Erwärmt man das Formgedächtnis-Polymer, so wird das Wachs weich und kann der Kraft des Federelements nicht mehr entgegenwirken, so dass das Formgedächtnis-Polymer wieder seine ursprüngliche Form annimmt.

Hinsichtlich direkter und indirekter Öffnung wird an dieser Stelle auf die entsprechenden Beschreibungen zu der Ausführungsform mit einer bimetallischen Komponente verwiesen, da die Anordnung und die Funktionsweise bei der Verwendung eines Formgedächtnismaterials im Wesentlichen identisch hierzu ist. Formgedächtnismaterial, also zum Beispiel eine Formgedächtnislegierung, ist ebenfalls thermisch sensitiv. Diese Sensitivität drückt sich durch die geometrische Veränderung der Form des Materials unter Temperatureinwirkung aus. So können beispielsweise Drähte oder Stäbe aus Formgedächtnismaterial verwendet werden, die ihre Form unter Einwirkung von Temperatur verändern. Da die Veränderung der Form unter Temperatureinwirkung auf Gefügeveränderungen im Material zurückgeht, nämlich der Übergang von Martensit auf Austenit und die damit einhergehende Gefügekompaktierung, reduziert sich dabei die Länge solcher Drähte bzw. Stäbe. Ein Stab als direkter Bestandteil des Sicherungsschalters wird sich also unter Einwirkung von Wärme zusammenziehen und damit, bei entsprechender geometrischer Anordnung der Kontakte des Sicherungsschalters, die Verbindung zu dem Verbrauchernetz dabei öffnen. Indirektes Öffnen kann bei der Verwendung eines im Wesentlichen biegesteifen Stabes durch Schieben des Sicherungsschalters, oder bei Verwendung eines Drahtes aus Formgedächtnismaterial, durch Ziehen des Sicherungsschalters in die geöffnete Position bewirkt werden. Ein Vorteil bei der Verwendung von Formgedächtnismaterial ist das sprungartige Verhalten dieses Materials. Auf diese Weise kann auch ein sprunghaftes Öffnen des Sicherungsschalters gewährleistet werden, so dass kein Übergang die Geschwindigkeit und damit die Sicherheit des Schaltvorganges beeinträchtigt.

Insbesondere bei Ausführungsformen ohne Sensoren, also bei der Ausbildung des Sicherungsschalters und/oder der Sicherungsvorrichtung mit der Auslösevorrichtung in integraler Bauweise, kann es von Vorteil sein, wenn eine Verrastung für den Sicherungsschalter vorgesehen ist, die diesen nach dem Öffnen in der geöffneten Position hält, unabhängig davon wie sich die Temperatur- und/oder die Rauchsituation verändert. Es kann also von Vorteil sein, wenn bei einem erfindungsgemäßem Photovoltaik-Modul die elektrische Sicherungsvorrichtung eine Verrastung für den Sicherungsschalter aufweist, die nach dem Öffnen des Sicherungsschalters zum Unterbrechen der Verbindung der Stromanschlüsse der elektrischen Anschlussvorrichtung zu dem Verbrauchernetz, diesen in der offenen Position verrastet. Mit anderen Worten rastet der Sicherungsschalter in der gesicherten Position, also in der offenen Position, ein, so dass ein anschließendes Wiederherstellen der Verbindung der Stromanschlüsse zu dem Verbrauchernetz durch diese Verrastung verhindert ist.

In einer bevorzugten Ausführungsform ist vorgesehen, dass die Verrastungsvorrichtung ein Rastmittel mit einer Auflaufschräge aufweist, über welche ein distales Ende des Sicherungsschalters bewegen kann.

Durch diese Bewegung beim Öffnen des Sicherungsschalters wird das Rastmittel aus seiner Ruheposition verschoben. Um sicherzustellen, dass das Rastmittel nach ausreichendem Öffnen des Sicherungsschalters wieder in die verrastende Position zurück bewegt wird, kann eine Rastfedervorgesehen sein, welche eine Kraftrichtung entgegen der Bewegungsrichtung des Rastmittels bei der Öffnung des Sicherungsschalters aufweist. Nach Erreichen der geöffneten Position des Sicherungsschalters verrastet das Rastmittel diesen in der geöffneten Position, so dass ein Schließen der elektrisch leitenden Verbindung zu dem Verbrauchernetz nicht mehr automatisch möglich ist. Dies hat unter anderem den Vorteil, dass die automatisch eingetretene Sicherung sich nicht automatisch, d.h. selbsttätig, lösen kann.

Ferner ist vorzugsweise vorgesehen, dass die Verrastungsvorrichtung eine Entsperrung zum manuellen Lösen der Verrastungsvorrichtung aufweist. Dies kann durch ein abschnittsweises Herausstehen des Rastmittels aus einem Gehäuse der Sicherungsvorrichtung gelöst werden. Über diesen herausstehenden Teil des Rastmittels kann dieses aktiv gegen die Rastfeder bewegt werden und auf diese Weise den Sicherungsschalter wieder freigeben.

Es kann auch ein Freigabeschalter vorgesehen sein, über welchen die Verrastung gelöst und damit der Sicherungsschalter wieder geschlossen werden kann. Durch die Verrastung verbleibt der Sicherungsschalter in der geöffneten Position, selbst wenn die Werte für Rauch und/oder oder Temperatur auf Werte fallen, die unterhalb der Auslösewerte liegen. Dies kann beispielsweise der Fall sein, wenn bei einem Brand in einem Gebäude mit dem Löschvorgang begonnen worden ist, und damit das Gebäude zumindest teilweise gekühlt wird. Ohne die Verrastung bestünde also die Gefahr, dass sich durch die Abkühlung des Gebäudes der Sicherungsschalter automatisch wieder schließt und damit die Sicherung der Leitungen im Gebäude noch während des Rettungsvorganges wieder aufgehoben wäre. Das Stromschlagrisiko würde demnach im Laufe der Rettungsarbeiten ansonsten erneut auftreten.

Weiter kann es vorteilhaft sein, wenn bei einem erfindungsgemäßen Photovoltaik-Modul die Auslösevorrichtung zumindest einen Sensor aufweist, der qualitativ oder quantitativ Rauch und/oder Temperatur in ein Sensorsignal umsetzen kann, und die Kopplung des Sicherungsschalters und der Auslösevorrichtung über eine Signalleitung und eine Stellvorrichtung für den Sicherungsschalter ausgebildet ist. Bei dieser Ausführungsform ist also zumindest ein Teil der Auslösevorrichtung von der Sicherungsvorrichtung und damit auch vom Sicherungsschalter getrennt. Insbesondere der sensitive Teil der Auslösevorrichtung ist in Form eins Sensors vorgesehen, der sein Sensorsignal über eine Signalleitung an die Sicherungsvorrichtung übermittelt. Bei derartigen Ausführungsformen kann es von Vorteil sein, wenn eine Stellvorrichtung für den Sicherungsschalter vorgesehen ist, mittels welcher der Sicherungsschalter zumindest in die geöffnete Stellung bewegt werden kann. Durch das Vorsehen eines Sensors, der separat von der Sicherungsvorrichtung angeordnet werden kann, ist unter anderem der Vorteil zu erzielen, dass für den Sensor Standardkomponenten verwendet werden können, die dementsprechend preiswert sind. Weiter kann die Abmessung der Sicherungsvorrichtung weiter verringert werden, da weniger Komponenten in einem gemeinsamen Gehäuse angeordnet werden müssen. Auch kann auf diese Weise eine Mehrfachnutzung von Sensoren erfolgen. So ist es zum Beispiel möglich, dass in einem Gebäude bereits vorhandene Sensoren und/oder oder Gebäudesteuersysteme verwendet werden können, um als Sensoren für die Auslösevorrichtung zu dienen. Dies ermöglicht eine bessere Abdeckung des Gebäudes mit Sensoren für die Auslösevorrichtung des Photovoltaik-Moduls und gleichzeitig eine Kostenreduktion für das erfindungsgemäße Photovoltaik-Modul. Für eine Auslösevorrichtung mit Sensoren kann dabei eine zentrale oder auch eine dezentrale Steuervorrichtung vorgesehen sein, die von den Sensoren erhaltene Signale neben weiteren Komponenten auch an ein erfindungsgemäßes Photovoltaik-Modul weiterleitet, bzw. für dieses aufarbeitet.

Im Rahmen der vorliegenden Erfindung kann es weiter von Vorteil sein, wenn zumindest ein Sensor der Auslösevorrichtung örtlich beabstandet vom dem Sicherungsschalter angeordnet ist. Insbesondere kann es von Vorteil sein, wenn bei einem erfindungsgemäßen Photovoltaik-Modul der zumindest eine örtlich von dem Sicherungsschalter beabstandete Sensor in der Umgebung des angeschlossenen Verbrauchernetzes angeordnet ist. Mit anderen Worten ist der Sensor vorteilhafter Weise in einem Bereich angeordnet, in welchem auch die Leitungen des Verbrauchernetzes verlaufen. Bei einem Gebäudestromnetz als Verbrauchernetz ist dies als Ort für den Sensor insbesondere das Gebäudeinnere, also der Bereich, der nicht nur als Brandherd in Frage kommt, sonder in welchem auch die Rettungskräfte sich bevorzugt während des Rettungseinsatzes bewegen. Damit kann der Sensor der Auslösevorrichtung die Sicherungsvorrichtung auch dann auslösen, wenn am Ort der Sicherungsvorrichtung, insbesondere am Ort der Photovoltaik-Zellen, noch keine Beeinträchtigung durch einen Brand vorherrscht. Da Photovoltaik-Zellen häufig auf den Dächern von Gebäuden angebracht sind, wird auf diese Weise sichergestellt, dass die Sicherungsvorrichtung auch bei einer Situation auslöst, bei der ein Brand im Inneren des Gebäudes vorliegt. Auf diese Weise wird der Auslösezeitpunkt der Auslösevorrichtung verfrüht, so dass die Auslösung der Sicherungsvorrichtung insbesondere bereits erfolgt ist, wenn die Rettungskräfte den Einsatzort erreichen, also noch bevor der Rettungseinsatz beginnt.

In vorteilhaften Ausführungsformen ist es möglich, dass die Auslösevorrichtung zumindest eine Sprengsicherung aufweist. Eine solche Sprengsicherung ist eine Möglichkeit, die Sicherungsvorrichtung auszulösen und den Sicherungsschalter in seine geöffnete Position zu bringen.

Um eine möglichst kompakte Bauweise des Photovoltaik-Moduls zu erzielen und insbesondere bereits vorhandene Komponenten bei Photovoltaik-Anlagen zu nutzen, kann es weiter von Vorteil sein, wenn die Auslösevorrichtung und/oder die Sicherungsvorrichtung zumindest teilweise in einer Modulanschlussdose des Photovoltaik-Moduls angeordnet sind. Auf diese Weise kann der Ort und das Gehäuse der bereits vorhandenen Modulanschlussdose verwendet werden, um die erfindungsgemäßen Komponenten des Photovoltaik-Moduls anzuordnen.

Nach einem weiteren Aspekt der Erfindung ist eine Kombination mehrerer Photovoltaik-Module vorgesehen, die jeweils nach der Erfindung ausgeführt sind, wobei mindestens eine Sicherungsvorrichtung eines Photovoltaik-Moduls zur Trennung des jeweils zugehörigen Stromanschlusses mit mindestens einer Sicherungsvorrichtung mindestens eines weiteren Photovoltaik-Moduls derart funktional gekoppelt ist, dass bei Aktivierung einer der Sicherungsvorrichtungen zur Trennung des jeweils zugehörigen Stromanschlusses die jeweils andere Sicherungsvorrichtung zur Trennung des jeweils zugehörigen Stromanschlusses daraufhin ebenfalls aktiviert wird, so dass die Kombination mehrerer Photovoltaik-Module insbesondere dann keinen elektrischen Strom abgibt, wenn eine Aktivierung bereits einer der Sicherungsvorrichtungen erfolgt ist.

Auf diese Weise wird eine Redundanz hinsichtlich der Sicherungsvorrichtungen erreicht.

Dabei ist insbesondere zumindest eine Sicherungsvorrichtung jedes Photovoltaik-Moduls über jeweils zumindest eine diskrete elektrische Signalleitung mit zumindest einer Sicherungsvorrichtung jedes weiteren Photovoltaik-Moduls der Kombination von Photovoltaik-Modulen verbindbar, wobei die zumindest eine diskrete elektrische Signalleitung derart an eine Sicherungsvorrichtung eines ersten Photovoltaik-Moduls elektrisch und funktional angeschlossen und derart an einer Sicherungsvorrichtung eines zweiten Photovoltaik-Moduls elektrisch und funktional angeschlossen ist, dass bei Aktivierung einer der miteinander über die Signalleitung verbundenen Sicherungsvorrichtungen zur Trennung des dieser jeweils zugehörigen Stromanschlusses die jeweils andere Sicherungsvorrichtung zur Trennung des dieser jeweils zugehörigen Stromanschlusses aktiviert, so dass die Kombination mehrerer Photovoltaik-Module keinen elektrischen Strom abgibt, wenn eine Aktivierung bereits einer der Sicherungsvorrichtungen erfolgt ist.

Durch diese Ausführungsform der Erfindung wird mit geringem technischen Aufwand eine große Sicherheit für die Abschaltung einer Kombination von Modulen erreicht. Diese Abschaltvorrichtung kann ohne oder im Wesentlichen ohne elektronische Komponenten realisiert werden, wenn die Kopplungstrennung der jeweiligen Sicherheitsvorrichtungen mittels mechanischer und/oder einfacher elektrischer Komponenten erfolgt. Beispielsweise kann die Sicherungsvorrichtung durch einen mechanisch in seine offene Stellung vorgespannten und mit der Ausgangsleitung der Photovoltaik-Zellen elektrisch verbundenen Schalter mit einem Kontaktelement realisiert sein, der durch Bewegung einer Sperrklinke von einer Verriegelungsstellung, in der der Schalter in seiner geschlossenen Stellung gegenüber der Anschlussleitung gehalten wird, in die Entriegelungsstellung freigegeben wird, so dass der Schalter mit dem Kontaktelement in seine offene Stellung gelangt, in der der Stromanschluss über das Kontaktelement in elektrische Verbindung mit der zugehörigen Anschlussleitung hergestellt wird.

In einer Ausführungsform der Erfindung kann vorgesehen sein, dass zwischen jeweils zwei Photovoltaik-Modulen nur eine elektrische Verbindungsleitung zur Kopplung der Sicherheitsvorrichtungen dieser Photovoltaik-Module angeschlossen ist. In diesem Fall kann ein Sicherheitsschaltmodul an jedem der Sicherungsschalter funktional angeordnet sein, der einerseits mit einem solchen Sicherungsschalter und andererseits mit der elektrischen Verbindungsleitung verbunden ist. Jedes Sicherheitsschaltmodul weist eine Erfassungsfunktion auf, mit der dieser durch Erfassung des Vorhandenseins oder Nicht-Vorhandenseins eines Stromflusses in der elektrischen Verbindungsleitung oder einer Spannung an derselben erfasst, ob der Sicherungsschalter des jeweils anderen Photovoltaik-Moduls in der offenen Stellung ist. Weiterhin kann jeder Sicherungsschalter eine Schaltfunktion aufweisen, mit der dieser den jeweils zugehörigen Sicherungsschalter durch entsprechende Betätigung der Sperrklinke in seine offene Stellung bringt, wenn die Erfassungsfunktion erfasst hat, dass der Sicherungsschalter des jeweils anderen Photovoltaik-Moduls in der offenen Stellung ist. Die elektrische Verbindungsleitung wird hierbei derart an einer Spannungsquelle angeschlossen oder mit Strom versorgt, dass die Erfassungsfunktion feststellen kann, ob Spannung in der elektrischen Verbindungsleitung anliegt oder Strom in derselben fließt, um auf diese Weise die offene Stellung des Sicherungsschalters zu ermitteln.

Dabei kann insbesondere vorgesehen sein, dass bei einem geschlossenen Schalter elektrische Spannung an der Leitung anliegt und bei offenen Stellung des Schalters keine elektrische Spannung an der Leitung anliegt oder kein elektrischer Strom in derselben fließt, so dass die Trennung des jeweiligen Stromanschlusses aufgrund dieser Bedingung erfolgt. Auf diese Weise kann eine höhere Sicherheit dieser Funktionalität erreicht werden, da ein Komponentenfehler im Sicherheitsschaltmodul nicht zu falschen Annahmen im Modul führen kann.

In einer alternativen Ausführungsform der Erfindung kann vorgesehen sein, dass zwischen jeweils zwei Photovoltaik-Modulen zwei elektrische Verbindungsleitungen zur Kopplung der Sicherheitsvorrichtungen verschiedener Photovoltaik-Module angeschlossen sind. In diesem Fall ist jeweils die Erfassungsfunktion eines Photovoltaik-Moduls mit der Schaltfunktion des jeweils anderen Photovoltaik-Moduls verbunden. Die weitere Funktionalität ist dabei wie zuvor an Hand der Ausführungsform des Sicherheitsschaltmoduls mit einer Verbindungsleitung zwischen zwei Photovoltaik-Modulen.

Alternativ dazu kann nach der Erfindung vorgesehen sein, dass die funktionale Verbindung der Sicherungsvorrichtung eines Photovoltaik-Moduls mit mindestens einer weiteren Sicherungsvorrichtung mindestens eines weiteren Photovoltaik-Moduls über eine Funkschnittstelle, insbesondere über Zigbee, erfolgt.

Dabei kann die Aktivierung jeweils einer der miteinander über die Signalleitung verbundenen Sicherungsvorrichtungen zur Trennung des dieser jeweils zugehörigen Stromanschlusses nach einer Ausführungsform der Erfindung erfolgen. Dies kann insbesondere durch Aktivierung der Auslösevorrichtung durch zumindest einen Sensor erfolgen, der derart in der Auslösevorrichtung integriert und derart ausgeführt ist, dass dieser aufgrund eines qualitativen oder quantitativen Erfassens von Rauch oberhalb einer vorbestimmten Intensität und/oder Temperatur oberhalb eines Schwellwertes ein Sensorsignal erzeugt, das die Auslösevorrichtung in einen Zustand versetzt, in dem der Stromanschluss oder in dem die Stromanschluss-Leitung, in dem bzw. in der die Auslösevorrichtung integriert ist, im Sinne der Aktivierung elektrisch unterbrochen wird und somit keinen Strom mehr an eine Zufuhrleitung eines Verbrauchernetzes oder an das Verbrauchernetz senden kann. Weiterhin kann dabei vorgesehen sein, dass der Sicherungsschalter und die Auslösevorrichtung über eine Signalleitung miteinander funktional verbunden sind und dass die Auslösevorrichtung eine Stellvorrichtung aufweist, die aufgrund des erzeugten Sensorsignals den Sicherungsschalter öffnet.

Bei diesen Ausführungsformen kann alternativ oder zusätzlich vorgesehen sein, dass die Sicherungsvorrichtung oder die Auslösevorrichtung mittels einer externen Benutzerschnittstelle wie einem Handgerät und insbesondere einem Funkgerät bedient und dabei zur Unterbrechung des Anschlusses eines Photovoltaik-Moduls an ein Verbrauchernetz und/oder zumindest einer elektrisch betriebenen Komponente aktiviert werden kann.

Durch diese Ausführungsformen werden die Zuverlässigkeit und die Sicherheit der gesamten Sicherungsfunktion zur Unterbrechung des Stromflusses in einer Ausgangsleitung oder Anschlussleitung, mit der die Kombination mehrerer Photovoltaik-Module von einem elektrischen Verbraucher und/oder einem Verbrauchernetz elektrisch abkoppelbar ist.

Einen weiteren Aspekt der vorliegenden Erfindung betrifft ein Gebäudestromnetz für die Versorgung von in einem Gebäude integrierten oder befindlichen Verbrauchern oder elektrisch betriebenen Komponenten mit elektrischem Strom, das als Verbrauchernetz mit wenigstens einem erfindungsgemäßen Photovoltaik-Modul elektrisch über dessen Anschlussvorrichtung mit elektrischem Strom versorgt wird. Besonders vorteilhaft ist die Anordnung von Photovoltaik-Zellen und insbesondere Photovoltaik-Modulen mit Photovoltaik-Zellen auf einem Dach eines Gebäudes und insbesondere eines Wohngebäudes. Auf diese Weise wird die Sicherheit dieser Gebäude mit Bezug auf Rettungseinsätze, beispielsweise bei Gebäudebränden, deutlich erhöht und die Rettungskräfte während des Einsatzes besser geschützt.

Erfindungsgemäß ist weiterhin eine Photovoltaik-Anlage mit einer Kombination mehrerer Photovoltaik-Modulen und einem Gebäudestromnetz für die Versorgung eines Gebäudes mit Strom vorgesehen, das von der Kombination mehrerer Photovoltaik-Modulen elektrisch über dessen Anschlussvorrichtung mit Strom versorgt wird, das die Photovoltaik-Anlage eine Statusinformations-Vorrichtung zur Information des allgemeinen Betriebszustandes, insbesondere aber zur Maßnahme der Trennung der Photovoltaik-Module von der Anschlussleitung elektrisch oder über eine Funkverbindung integriert ist, die die Trennung des jeweils zugehörigen Stromanschlusses von dem Gebäudestromnetz nach einer oder mehreren der folgenden Alternativen ausgeführt ist:
■ die Statusinformations-Vorrichtung ist als optische Informations-Vorrichtung und insbesondere als Signal-Lampe oder LED ausgeführt und/oder
■ die Statusinformations-Vorrichtung ist als akustische Informations-Vorrichtung und insbesondere mit einem Sprachmodul ausgeführt,
wobei die Statusinformations-Vorrichtung insbesondere einen Akku aufweist, der von den Photovoltaik-Modulen in ihrem Normalbetrieb aufladbar ist.

Mit einer solchen Statusinformations-Vorrichtung wird sichergestellt, dass die Statusinformations-Vorrichtung auch dann eine Statusinformation vermitteln und insbesondere ein akustisches oder optisches Signal senden kann, wenn kein oder nicht ausreichendes Tageslicht herrscht.

Durch das Vorsehen eines Akkus und dessen elektrische Kopplung zu den Modulen ist sichergestellt, dass die Statusinformations-Vorrichtung hinsichtlich ihres Energiezustands jederzeit einsatzfähig ist.

Die Statusinformations-Vorrichtung kann separat oder integriert ausgebildet sein: in einem, mehreren oder jedem der Photovoltaik-Module, an derjenigen Stelle, an der die Photovoltaik-Module jeweils elektrisch verbindbar sind, oder an oder in dem Wechselrichter. Insbesondere kann die Statusinformations-Vorrichtung, z.B. eine Signallampe, auch am Schaltschrank im Gebäude angebracht sein. Bei der Ausführung der Statusinformations-Vorrichtung als akustische Informations-Vorrichtung kann diese ein Sprachmodul aufweisen, um die Statusinformationen eine Sprachausgabe anzuzeigen.

Die Statusinformations-Vorrichtung kann insbesondere derart funktional ausgeführt sein, dass diese eine akustische und/oder optische Information angibt, wenn die Sicherungsvorrichtung in einen Zustand gebracht wird, bei dem die Trennung eines Stromanschlusses erfolgt ist.

Bei der Schaltung der Photovoltaik-Anlage in einen Zustand, in dem die Verbindung eines Stromanschlusses erfolgt ist, kann insbesondere vorgesehen sein: eine erste optische Anzeige, die anzeigt, dass über Funk die Kommandierung dieser Verbindung eines Stromanschlusses erfolgt ist, und eine zweite optische Anzeige, die anzeigt, dass die Verbindung eines Stromanschlusses erfolgt ist.

Bei der Schaltung der Photovoltaik-Anlage in einen Zustand, in dem die Trennung eines Stromanschlusses erfolgt ist, kann insbesondere vorgesehen sein: eine erste optische Anzeige, die anzeigt, dass über Funk die Kommandierung dieser Trennung eines Stromanschlusses erfolgt ist, und eine zweite optische Anzeige, die anzeigt, dass die Trennung eines Stromanschlusses erfolgt ist.

Die vorliegende Erfindung wird nachfolgend anhand von Ausführungsformen mit Bezug auf die beigefügten Figuren erläutert. Dabei beziehen sich die verwendeten Begriffe "links", "rechts", "oben" und "unten" auf die Darstellung der Figuren mit einer Ausrichtung, bei der in den Figuren Bezugszeichen normal lesbar sind. Es zeigen:
- Fig. 1: eine erste Ausführungsform eines erfindungsgemäßen Photovoltaik-Moduls,
- Fig. 2: eine weitere Ausführungsform eines erfindungsgemäßen Photovoltaik-Moduls,
- Fig. 3: eine weitere Ausführungsform eines erfindungsgemäßen Photovoltaik-Moduls,
- Fig. 4a: eine Ausführungsform einer Sicherungsvorrichtung mit Sicherungsschalter in geöffneter Position,
- Fig. 4b: die Ausführungsform der Fig. 4a mit Sicherungsschalter in geschlossener Position,
- Fig. 5a: eine Ausführungsform einer Sicherungsvorrichtung mit Sicherungsschalter in geöffneter Position,
- Fig. 5b: die Ausführungsform der Fig. 5a mit Sicherungsschalter in geschlossener Position,
- Fig. 6: eine schematische Darstellung einer möglichen Anordnung erfindungsgemäßer Photovoltaik-Module auf einem Gebäude.

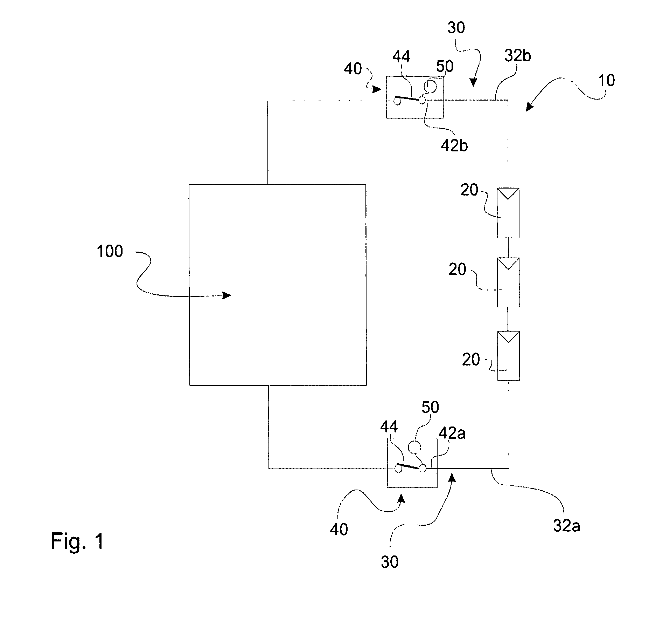

In Fig. 1 ist eine erste Ausführungsform des erfindungsgemäßen Photovoltaik-Moduls 10 dargestellt. Das Photovoltaik-Modul 10 dieser Ausführungsform ist in Fig. 1 in der Nutzungssituation dargestellt, also zu einem Zeitpunkt, an welchem die elektrische Kopplung mit einem Verbrauchernetz 100 besteht. Bei dem Verbrauchernetz 100 kann es sich beispielsweise um ein gebäudeinternes Netz 100b zur Versorgung des Gebäudes mit elektrischen Strom handeln. Auch ist es möglich, dass das Verbrauchernetz 100 ein öffentliches Stromnetz 100a ist, in welches der vom Photovoltaik-Modul 10 erzeugte Strom eingespeist wird.

Das Photovoltaik-Modul 10 dieser Ausführungsform ist beispielhaft mit drei in Reihe geschalteten Photovoltaik-Zellen 20 ausgestattet. Selbstverständlich können jedoch auch mehr als drei Photovoltaik-Zellen 20 in einem Photovoltaik-Modul 10 zusammengefasst sein.

Das Photovoltaik-Modul 10 dieser Ausführungsform weist eine Anschlussvorrichtung 30 auf, die über zwei Stromanschlüsse 32a und 32b mit dem Verbrauchernetz 100 gekoppelt ist. Mit den beiden Stromanschlussvorrichtungen 32a und 32b ist eine Sicherungsvorrichtung 40 verbunden, die bei der Ausführungsform der Fig. 1 zweiteilig ausgeführt ist. In jedem dieser Teile der Sicherungsvorrichtung 40 ist ein Sicherungsschalter 44 vorgesehen, der über Sicherungsanschlüsse 42a und 42b mit den Stromanschlussvorrichtungen 32a und 32b in elektrisch leitender Verbindung steht. Somit die drei Photovoltaik-Zellen 20, die Sicherungsschalter 44 und das Verbrauchernetz 100 eine Reihenschaltung. Über diese Sicherungsvorrichtung 40, insbesondere über den Sicherungsschalter 44, wird jeweils die elektrisch leitende Verbindung zu dem Verbrauchernetz 100 hergestellt. Um dies zu gewährleisten sind bei der Nutzungssituation gemäß der Fig. 1 die beiden Sicherungsschalter 44 geschlossen und schließen auf diese den entsprechenden Stromkreis zwischen Photovoltaik-Zellen 20 und Verbrauchernetz 100. In besonders einfachen Ausführungsformen kann es auch sinnvoll sein, wenn die Sicherungsvorrichtung 40 nur einen Sicherungsschalter 44 aufweist, der den Stromkreis zwischen Photovoltaik-Zellen 20 und Verbrauchernetz 100 an einer Stelle unterbrechen kann.

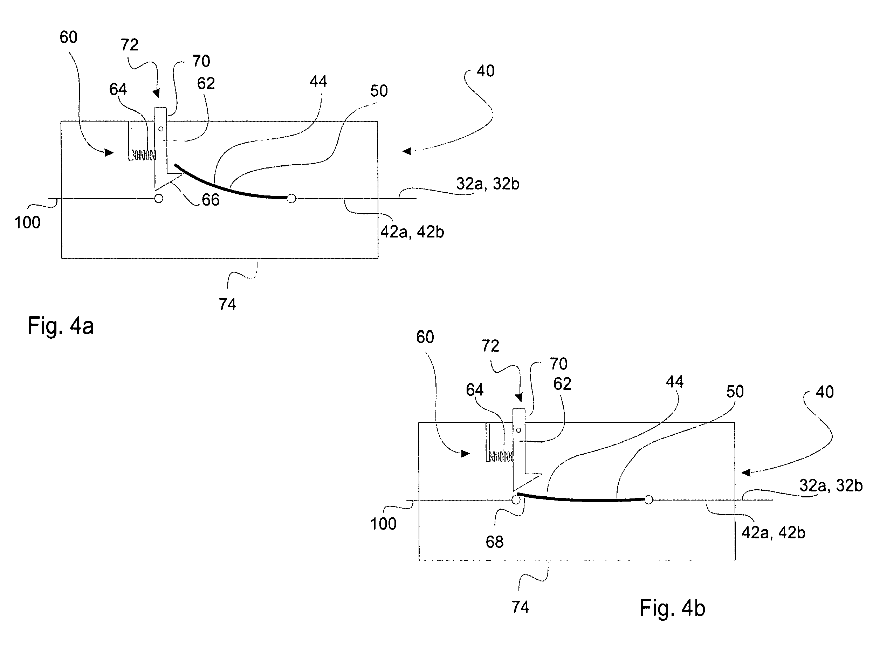

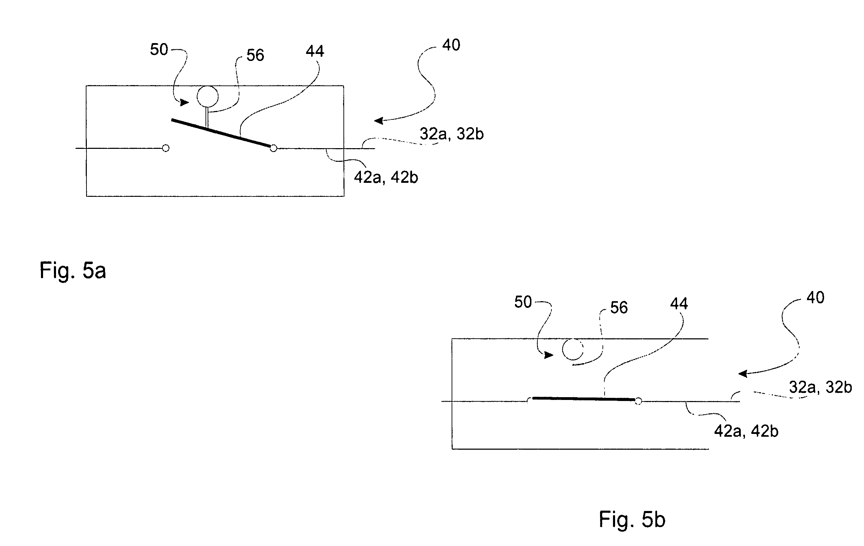

Um die Sicherheit des Photovoltaik-Moduls 10 erfindungsgemäß zu erhöhen, ist für die Sicherungsvorrichtung 40 eine Auslösevorrichtung 50 vorgesehen. Diese ist in der Ausführungsform der Fig. 1 integral mit der Sicherungsvorrichtung 40 bzw. integral mit dem Sicherungsschalter 44 ausgeführt. Details zu einer solchen Ausführungsform sind beispielsweise den Ausführungsform der Fig. 4a, 4b, 5a und 5b zu entnehmen, die später noch ausführlich erläutert werden. Diese Auslösevorrichtung 50 ist thermisch sensitiv und/oder rauchsensitiv. Das bedeutet, dass bei Erfassen einer Überschreitung einer vordefinierten Temperaturgrenze und/oder der Erfassung von Rauch in quantitativer und/oder qualitativer Weise die Auslösevorrichtung 50 den Sicherungsschalter 44 der Sicherungsvorrichtung 40 öffnet und auf diese Weise die Photovoltaik-Zellen 20 von dem Verbrauchernetz 100 elektrisch trennt. Geöffnete Sicherungsschalter 44 sind beispielsweise in den Fig. 4a und 5a dargestellt.

Die Ausführungsform der Fig. 1 kann beispielsweise mit Sicherungsschaltern 44 versehen sein, die eine bimetallische Komponente und/oder eine Komponente aus Formgedächtnismaterial aufweisen.

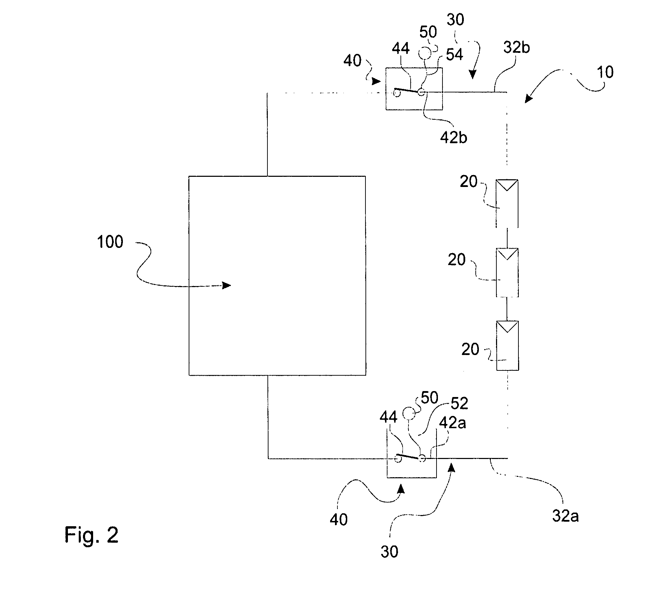

In der Fig. 2 ist eine weitere Ausführungsform des erfindungsgemäßen Photovoltaik-Moduls 10 dargestellt, die eine Variation der Ausführungsform der Fig. 1 ist. Bei dieser Variation ist die Auslösevorrichtung 50 nicht mehr integral mit der Sicherungsvorrichtung 40 ausgebildet, sondern vielmehr separat von dieser. Die Auslösevorrichtung 50 ist dabei über eine Signalleitung 54 mit der Sicherungsvorrichtung 40, insbesondere dem Sicherungsschalter 44, gekoppelt. Bei dieser Ausführungsform ist insbesondere eine Stellvorrichtung 56 vorgesehen, wie sie in den Fig. 5a und 5b schematisch gezeigt ist und aus Übersichtlichkeitsgründen in der Darstellung der Fig. 2 fehlt. Die beispielsweise mit thermischen Sensoren und/oder Rauchmeldern ausgestattete Auslösevorrichtung 50 ist dabei von der Sicherungsvorrichtung 40 beabstandet angeordnet.

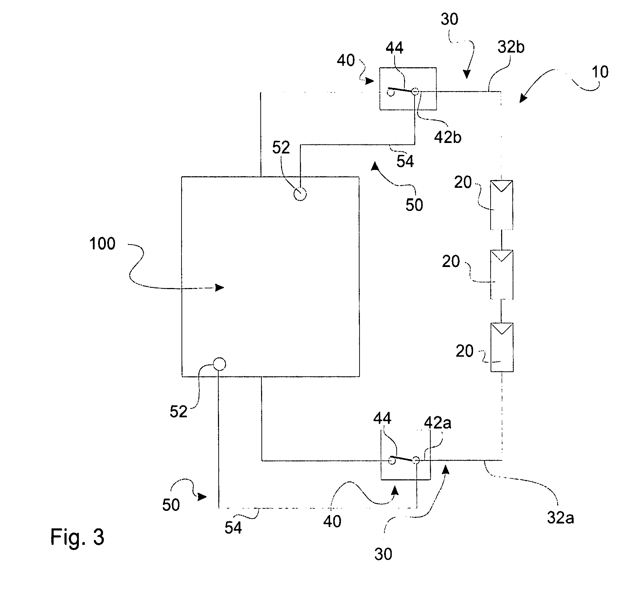

Fig. 3 zeigt eine weitere Ausführungsform eines erfindungsgemäßen Photovoltaik-Moduls 10, als weitere Variation der Ausführungsformen der Fig. 1 und 2. Bei dieser Ausführungsform ist der Abstand zwischen dem Sensor 52 der Auslösevorrichtung 50 und der Sicherungsvorrichtung 40 deutlich größer als bei Fig. 2. Insbesondere ist der Sensor 52, bzw. im Fall der Fig. 3 die beiden Sensoren 52, in der Umgebung des Verbrauchernetzes 100 angeordnet. Das bedeutet, dass bei Notsituation, wie zum Beispiel Bränden, im Bereich des Verbrauchernetzes 100 diese Sensoren 52 den Brand erkennen können, bereits bevor er sich bis zu den Photovoltaik-Zellen 20 ausgebreitet hat. Da Photovoltaik-Zellen 20 zumeist auf Dächern von Gebäuden angeordnet werden, erfolgt das gewünschte Sicherungsabschalten durch die Sicherungsvorrichtung 40 also noch vor dem vollständigen Ausbreiten des Brandes bis auf das Dach oder die Fassade des Gebäudes und damit zu einem sehr frühen Zeitpunkt, so dass insbesondere bereits vor dem Eintreffen der Rettungskräfte die automatische Abschaltung, also das Öffnen des Sicherungsschalters 44 erfolgt ist.

In den Fig. 4a und 4b ist eine Ausführungsform einer erfindungsgemäßen Sicherungsvorrichtung 40 dargestellt. Bei dieser Ausführungsform ist die Auslösevorrichtung 50 integral mit der Sicherungsvorrichtung 40, insbesondere sogar integral mit dem Sicherungsschalter 44, ausgebildet. Die Auslösevorrichtung 40 weist eine bimetallische Komponente auf, die bei dieser Ausführungsform den gesamten Sicherungsschalter 44 der Sicherungsvorrichtung 40 bildet. Die Fig. 4b zeigt die Situation im Nutzungszustand des Photovoltaik-Moduls 10, also mit einem Sicherungsschalter 44 im geschlossenen Zustand. In dieser Position des Sicherungsschalters 44 ist eine elektrisch leitende Verbindung zwischen dem Photovoltaik-Modul 10, also über den Stromanschluss 32a und 32b und den Sicherungsanschluss 42a und 42b mit dem Verbrauchernetz 100 hergestellt.

Führt nun eine Notsituation, beispielsweise ein Brand in einem Gebäude zu einer erhöhten Temperatur, so reagiert der Sicherungsschalter 44 mit einer Formveränderung des Bimetalls. Dieses verbiegt sich aufgrund der Materialkombination und der geometrischen Anordnung desselben nach oben und löst auf diese Weise die elektrische Verbindung zwischen dem Sicherungsanschluss 42a, 42b und dem Verbrauchernetz 100. Durch das Aufbiegen des Sicherungsschalters 100 wird also diese elektrisch leitende Verbinnung getrennt und damit ein Gebäude mit einem derartigen Photovoltaik-Modul 10 für einen Rettungseinsatz zum Löschen des Brandes gesichert.

Weiter weist die Ausführungsform der Fig. 4a und 4b exemplarisch eine Verrastung oder Verrastungsvorrichtung 60 auf. Diese dient dazu den Sicherungsschalter 44 nach dem Öffnen in seiner geöffneten Position zu halten, selbst wenn die Umgebungsparameter den Sicherungsschalter 44 eigentlich wieder schließen würden. Sinkt also die Temperatur beispielsweise durch das Andauern eines Löschvorganges durch die Rettungskräfte ab, so verformt sich die bimetallische Komponente der Sicherungsvorrichtung 40, insbesondere ein bimetallischer Sicherungsschalter 44, wieder zurück in eine Form, die die Verbindung zu dem Verbrauchernetz 100 wieder schließen würde. Um dies zu Verhindern, da die Löscharbeiten noch andauern und damit die weitere Sicherung des Gebäudes notwendig ist, dient eine Verrastungsvorrichtung 60 dazu, das Schließen des Sicherungsschalters 44 zu verhindern.

Um dies zu erzielen, kann die Verrastungsvorrichtung 60 beispielweise ausgebildet sein, wie es der Ausführungsform der Fig. 4a und 4b zu entnehmen ist. Ein Rastmittel 64 ist mit einer schiefen Ebene bzw. Auflaufschräge 66 versehen, über welche sich der Sicherungsschalter 44 mit seinem Endabschnitt bzw. distalen Ende 68 bewegen kann. Durch diese Bewegung beim Öffnen des Sicherungsschalters 44 wird das Rastmittel 64 aus seiner Ruheposition verschoben. Dies geschieht bei der Ausführungsform der Fig. 4a und 4b durch ein Verschieben des Rastmittels 64 nach links. Um sicherzustellen, dass das Rastmittel 64 nach ausreichendem Öffnen des Sicherungsschalters 44 wieder in die verrastende Position zurück bewegt wird, ist eine Rastfeder 64 vorgesehen, welche eine Kraftrichtung entgegen der Bewegungsrichtung des Rastmittels 64 bei der Öffnung des Sicherungsschalters 44 aufweist. Nach Erreichen der geöffneten Position des Sicherungsschalters 44 verrastet das Rastmittel 64 diesen in der geöffneten Position, so dass ein Schließen der elektrisch leitenden Verbindung zu dem Verbrauchernetz 100 nicht mehr automatisch möglich ist.

Um Beispielsweise im Falle eines Fehlalarms den Sicherungsschalter 44 auch wieder schließen zu können, kann die Verrastungsvorrichtung 60 eine Entsperrung 72 aufweisen, die ein manuelles Lösen der Verrastungsvorrichtung 60 erlaubt. Bei der Ausführungsform der Fig. 4a und 4b ist dies durch ein abschnittsweises Herausstehen des Rastmittels 64 aus einem Gehäuse 74 der Sicherungsvorrichtung 40 gelöst. Über diesen herausstehenden Teil 70 des Rastmittels 64 kann dieses aktiv gegen die Rastfeder 62 bewegt werden und auf diese Weise den Sicherungsschalter wieder freigeben.

In den Fig. 5a und 5b ist eine Ausführungsform einer Sicherungsvorrichtung 40 mit einer Stellvorrichtung 56 gezeigt. Die Stellvorrichtung 56 ist Teil der Auslösevorrichtung 50 und wirkt in dieser Ausführungsform mechanisch auf den Sicherungsschalter 44. Mit anderen Worten dient die Stellvorrichtung 56 dazu auf Befehl der Auslösevorrichtung 50, beispielweise nach Erhalt eines entsprechenden Signals, den Sicherungsschalter 44 zu öffnen und/oder zu schließen. Die kann durch Drücken und/oder durch Ziehen des Sicherungsschalters 44 erfolgen. Das Signal für die Stellvorrichtung 56 kann dabei von einem oder mehreren Sensoren 52 erzeugt werden, der/die Teil der Sicherungsvorrichtung 40 ist/sind, oder, wie in der Ausführungsformen der Fig. 2 und 3 gezeigt, von dieser beabstandet angeordnet ist/sind.

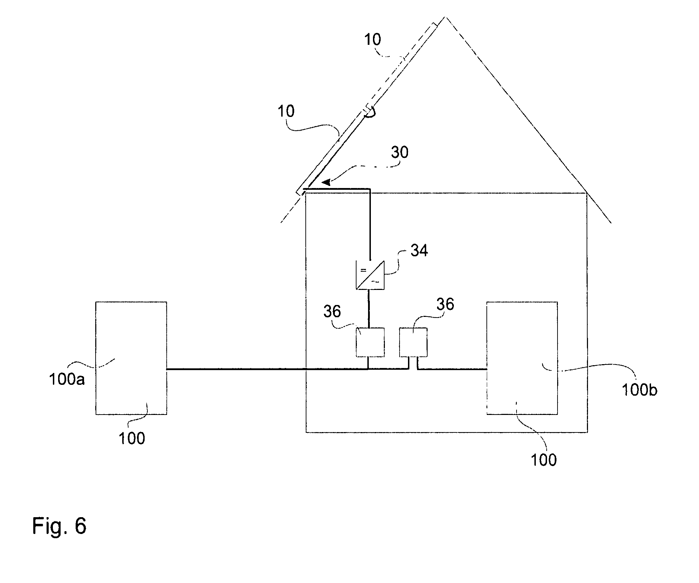

In der Fig. 6 ist schematisch eine mögliche Anordnung erfindungsgemäßer Photovoltaik-Module 10 auf einem Gebäude dargestellt. Die Photovoltaik-Module 10 sind bei dieser Ausführungsform auf dem Dach eines Gebäudes angeordnet und werden dort der Einstrahlung von Licht, zum Beispiel Sonnenlicht, ausgesetzt. Der durch die Lichteinstrahlung in den Photovoltaik-Zellen 20 der Photovoltaik-Module 10 erzeugte Strom ist ein Gleichstrom, der über die Anschlussvorrichtung 30 zumindest eines der Photovoltaik-Module 10 in das Gebäude geleitet wird und dort mittels eines Wechselrichters 34 in Wechselstrom umgewandelt wird. Der Wechselrichter 34 dient dazu, die erzeugte elektrische Leistung an die vorgegebenen Parameter der versorgten Verbrauchernetze 100 anzupassen.

In der Ausführungsform der Fig. 6 sind in kombinierter Weise zwei verschiedene Verbrauchernetze 100 dargestellt. Bei dem linken Verbrauchernetz 100 handelt es sich um ein öffentliches Stromnetz 100a, in welches die von den Photovoltaik-Modulen 10 erzeugte Leistung eingespeist wird. Um die Vergütung für die Einspeisung berechnen zu können, wird diese Leistung über eine Sicherungs- und Zählvorrichtung 36 geführt. In der Ausführungsform der Fig. 6 zusätzlich, aber grundsätzlich auch in eigenständiger Weise möglich, ist im Gebäude ein weiteres Verbrauchernetz 100 in Form eines gebäudeinternen Stromnetzes 100b vorgesehen. Die Photovoltaik-Module 10 auf dem Dach des Gebäudes können demnach auch das Stromnetz 100b im Gebäude selbst mit Strom versorgen. Um den Verbrauch hierfür erfassen zu können ist in der Abzweigung zum dem gebäudeinternen Stromnetz 100b ebenfalls eine Sicherungs- und Zählvorrichtung angeordnet.

Die einzelnen Photovoltaik-Module 10 auf dem Dach des Gebäudes sind diskret in Reihe einzeln miteinander verbunden, so dass das Auslösen der elektrischen Sicherungsvorrichtung 40 eines der Photovoltaik-Module 10 ausreicht, um das System aller Photovoltaik-Module 10 auf dem Dach des Gebäudes in einen gesicherten Zustand zu versetzen, in welchem keine elektrische Leistung in das Innere des Gebäudes geleitet wird. Hierdurch wird die Sicherheit noch weiter erhöht, da eine einzige Auslösung ausreicht, um die Sicherung zu erzielen und da das System aus einer Mehrzahl von Photovoltaik-Modulen 10 auf diese Weise sozusagen redundant gesichert ist.

### Bezugszeichenliste

- 10: Photovoltaik-Modul
- 20: Photovoltaik-Zelle
- 30: Anschlussvorrichtung
- 32a: Stromanschluss
- 32b: Stromanschluss
- 34: Wechselrichter
- 36: Schutz- und Zähleinrichtung
- 40: elektrische Sicherungsvorrichtung
- 42a: Sicherungsanschlüsse
- 42b: Sicherungsanschlüsse
- 44: Sicherungsschalter
- 50: Auslösevorrichtung
- 52: Sensor
- 54: Signalleitung
- 56: Stellvorrichtung
- 60: Verrastungsvorrichtung
- 62: Rastmittel
- 64: Rastfeder
- 66: Auflaufschräge
- 68: distales Ende
- 70: herausstehendes Teil
- 72: Entsperrung
- 74: Gehäuse
- 100: Verbrauchernetz
- 100a: öffentliches Stromnetz
- 100b: gebäudeinternes Stromnetz

## Patentansprüche

1. Photovoltaik-Modul (10) mit einer Mehrzahl einzelner Photovoltaik-Zellen (20), das Photovoltaik-Modul (10) aufweisend:
eine elektrische Anschlussvorrichtung (30) mit Stromanschlüssen (32a, 32b) zur Abgabe von erzeugtem Photovoltaikstrom an ein Verbrauchernetz (100),
eine elektrische Sicherungsvorrichtung (40) mit Sicherungsanschlüssen (42a, 42b) an den Stromanschlüssen (32a, 32b) der elektrischen Anschlussvorrichtung (30) und wenigstens einem Sicherungsschalter (44), über den die Stromanschlüsse (32a, 32b) der elektrischen Anschlussvorrichtung (30) von dem Verbrauchernetz (100) elektrisch getrennt werden können, wobei die elektrische Sicherungsvorrichtung (40) eine Auslösevorrichtung (50) aufweist, die mit einer thermischen Sensitivität und/oder einer Rauchsensitivität gebildet und mit dem Sicherungsschalter (44) derart verbunden ist,
dass auf Erfassen einer Temperatur und/oder von Rauch oberhalb eines vorbestimmten Schwellwertes der Sicherungsschalter (44) die Stromanschlüsse (32a, 32b) der elektrischen Anschlussvorrichtung (30) von dem Verbrauchernetz (100) elektrisch trennt.

2. Photovoltaik-Modul (10) nach Anspruch 1, **dadurch gekennzeichnet, dass** die Auslösevorrichtung (50) integraler Bestandteil des Sicherungsschalters (44) und/oder der Sicherungsvorrichtung (40) ist.

3. Photovoltaik-Modul (10) nach Anspruch 2, **dadurch gekennzeichnet, dass** die Auslösevorrichtung (50) eine Komponente aus Bimetall aufweist, die derart mit dem Sicherungsschalter (44) verbunden ist, dass die Auslösevorrichtung (50) bei Erhöhung der Temperatur den Sicherungsschalter (44) direkt oder indirekt elektrisch trennt.

4. Photovoltaik-Modul (10) nach Anspruch 2 oder 3, **dadurch gekennzeichnet, dass** die Auslösevorrichtung (50) eine Komponente aus Formgedächtnismaterial aufweist, die derart mit dem Sicherungsschalter (44) verbunden ist, dass die Auslösevorrichtung (50) bei Erhöhung der Temperatur den Sicherungsschalter (44) direkt oder indirekt elektrisch trennt.

5. Photovoltaik-Modul (10) nach einem der vorangegangenen Ansprüche, **dadurch gekennzeichnet, dass** die elektrische Sicherungsvorrichtung (40) eine Verrastungsvorrichtung (60) für den Sicherungsschalter (44) aufweist, die nach dem elektrisch Trennen durch Öffnen des Sicherungsschalters (44) zum Unterbrechen der Verbindung der Stromanschlüsse (32a, 32b) der elektrischen Anschlussvorrichtung (30) zu dem Verbrauchernetz (100) den Sicherungsschalter (44) in einer geöffneten Position verrastet.

6. Photovoltaik-Modul (10) nach Anspruch 5, **dadurch gekennzeichnet, dass** die Verrastungsvorrichtung (60) ein Rastmittel (64) mit einer Auflaufschräge (66) aufweist, über welche ein distales Ende (68) des Sicherungsschalters (44) bewegen kann.

7. Photovoltaik-Modul (10) nach Anspruch 5 oder 6, **dadurch gekennzeichnet, dass** die Verrastungsvorrichtung (60) eine Entsperrung (72) zum manuellen Lösen der Verrastungsvorrichtung (60) aufweist.

8. Photovoltaik-Modul (10) nach einem der vorangegangenen Ansprüche, **dadurch gekennzeichnet, dass** die Auslösevorrichtung (50) zumindest einen Sensor (52) aufweist, der aufgrund eines qualitativen oder quantitativen Erfassens von Rauch oberhalb einer vorbestimmten Intensität und/oder Temperatur oberhalb eines Schwellwertes ein Sensorsignal erzeugt, dass der Sicherungsschalter (44) und die Auslösevorrichtung (50) über eine Signalleitung (54) miteinander funktional verbunden sind, und dass die Auslösevorrichtung (50) eine Stellvorrichtung (56) aufweist, die aufgrund des erzeugten Sensorsignals zum elektrischen Trennen den Sicherungsschalter (44) öffnet.

9. Photovoltaik-Modul (10) nach Anspruch 8, **dadurch gekennzeichnet, dass** zumindest der Sensor (52) der Auslösevorrichtung (50) örtlich beabstandet vom dem Sicherungsschalter (44) angeordnet ist.

10. Photovoltaik-Modul (10) nach Anspruch 9, **dadurch gekennzeichnet, dass** der zumindest eine örtlich von dem Sicherungsschalter (44) beabstandete Sensor (52) in der Umgebung des angeschlossenen Verbrauchernetzes (100) angeordnet ist.

11. Photovoltaik-Modul (10) nach einem der vorangegangenen Ansprüche, **dadurch gekennzeichnet, dass** die Auslösevorrichtung (50) zumindest eine Sprengsicherung aufweist.

12. Photovoltaik-Modul (10) nach einem der vorangegangenen Ansprüche, **dadurch gekennzeichnet, dass** die Auslösevorrichtung (50) und/oder die Sicherungsvorrichtung (40) zumindest teilweise in einer Modulanschlussdose des Photovoltaik-Moduls (10) angeordnet sind.

13. Kombination mehrerer Photovoltaik-Module (10), die nach einem der Ansprüche 1 bis 12 ausgeführt sind, **dadurch gekennzeichnet, dass** mindestens eine Sicherungsvorrichtung (40) eines Photovoltaik-Moduls (10) zur Trennung des jeweils zugehörigen Stromanschlusses (32a, 32b) mit mindestens einer derartigen Sicherungsvorrichtung (40) mindestens eines weiteren Photovoltaik-Moduls (10) derart funktional gekoppelt ist, dass bei Aktivierung einer der Sicherungsvorrichtungen (40) zur Trennung des jeweils zugehörigen Stromanschlusses (32a, 32b) die jeweils andere Sicherungsvorrichtung (40) zur Trennung des jeweils zugehörigen Stromanschlusses (32a, 32b) daraufhin ebenfalls aktiviert wird, so dass die Kombination mehrerer Photovoltaik-Module (10) insbesondere dann elektrisch getrennt ist, wenn eine Aktivierung bereits einer der Sicherungsvorrichtungen (40) erfolgt ist.

14. Kombination mehrerer Photovoltaik-Module (10) nach dem Anspruch 13, **dadurch gekennzeichnet, dass** die funktionale Kopplung der Sicherungsvorrichtung (40) eines Photovoltaik-Moduls mit mindestens einer weiteren Sicherungsvorrichtung (40) mindestens eines weiteren Photovoltaik-Moduls über eine diskrete elektrische Signalleitung erfolgt.

15. Kombination mehrerer Photovoltaik-Module (10) nach einem der Ansprüche 13 oder 14, **dadurch gekennzeichnet, dass** zumindest eine Sicherungsvorrichtung (40) jedes Photovoltaik-Moduls (10) über jeweils zumindest eine diskrete elektrische Signalleitung mit zumindest einer Sicherungsvorrichtung (40) jedes weiteren Photovoltaik-Moduls (10) der Kombination von Photovoltaik-Modulen (10) verbunden ist, wobei die zumindest eine diskrete elektrische Signalleitung derart an eine Sicherungsvorrichtung (40) eines ersten Photovoltaik-Moduls (10) elektrisch und funktional angeschlossen und derart an einer Sicherungsvorrichtung (40) eines zweiten Photovoltaik-Moduls (10) elektrisch und funktional angeschlossen ist, dass bei Aktivierung einer der miteinander über die Signalleitung verbundenen Sicherungsvorrichtungen (40) zur Trennung des dieser jeweils zugehörigen Stromanschlusses (32a, 32b) die jeweils andere Sicherungsvorrichtung (40) zur Trennung des dieser jeweils zugehörigen Stromanschlusses (32a, 32b) aktiviert, so dass die Kombination mehrerer Photovoltaik-Module (10) elektrisch getrennt ist, wenn eine Aktivierung bereits einer der Sicherungsvorrichtungen (40) erfolgt ist.

16. Kombination mehrerer Photovoltaik-Module (10) nach einem der Ansprüche 13 bis 15, **dadurch gekennzeichnet, dass** die funktionale Kopplung der Sicherungsvorrichtung (40) eines Photovoltaik-Moduls mit mindestens einer weiteren Sicherungsvorrichtung (40) mindestens eines weiteren Photovoltaik-Moduls über eine Funkschnittstelle, insbesondere über Zigbee, erfolgt.

17. Photovoltaik-Anlage mit einer Kombination mehrerer Photovoltaik-Modulen (10) nach einem der Ansprüche 13 bis 16 und einem Gebäudestromnetz (100b) für die Versorgung eines Gebäudes mit elektrischem Strom, das von der Kombination mehrerer Photovoltaik-Modulen (10) elektrisch über dessen Anschlussvorrichtung (30) mit elektrischem Strom versorgt wird, das die Photovoltaik-Anlage eine Statusinformations-Vorrichtung zur Information der Maßnahme der Trennung der Photovoltaik-Module (10) von der Anschlussleitung elektrisch oder über eine Funkverbindung integriert ist, die die Trennung des jeweils zugehörigen Stromanschlusses (32a, 32b) von dem Gebäudestromnetz (100b) nach einer oder mehreren der folgenden Alternativen ausgeführt ist:
■ die Statusinformations-Vorrichtung ist als optische Informations-Vorrichtung und insbesondere als Signal-Lampe oder LED ausgeführt und/oder
■ die Statusinformations-Vorrichtung ist als akustische Informations-Vorrichtung und insbesondere mit einem Sprachmodul ausgeführt,
wobei die Statusinformations-Vorrichtung insbesondere einen Akku aufweist, der von den Photovoltaik-Modulen (10) in ihrem Normalbetrieb aufladbar ist.
